# EUROPÄISCHE PATENTSCHRIFT

(11) **EP 0 809 860 B1**
(45) Veröffentlichungstag und Bekanntmachung des Hinweises auf die Patenterteilung: **28.04.2004**
(21) Anmeldenummer: 96901234.3
(22) Anmeldetag: 01.02.1996
(51) Int. Cl.: H01L 21/74, H01L 21/28, H01L 21/321

(54) **Verfahren zur Herstellung einer SCHICHTSTRUKTUR MIT EINER SILICID-SCHICHT**
Process for producing a LAYERED STRUCTURE WITH A SILICIDE LAYER
Procédé pour la fabrication d'une STRUCTURE STRATIFIEE COMPORTANT UNE COUCHE DE SILICIURE

(30) Priorität: 06.02.1995 DE 19503641
(43) Veröffentlichungstag der Anmeldung: 03.12.1997
(73) Patentinhaber: Forschungszentrum Jülich GmbH, 52425 Jülich (DE)
(72) Erfinder: MANTL, Siegfried, D-52428 Jülich (DE)
(86) Internationale Anmeldenummer: PCT/DE1996/000172
(87) Internationale Veröffentlichungsnummer: WO 1996/024952

(56) Entgegenhaltungen:
- EP-A- 0 547 030
- US-A- 4 900 396
- US-A- 4 971 655
- IBM TECHNICAL DISCLOSURE BULLETIN, Bd. 33, Nr. 10a, März 1991 NEW YORK US, Seiten 218-219, XP 000110021 'patterning and etching of silicide layers'
- IBM TECHNICAL DISCLOSURE BULLETIN, Bd. 34, Nr. 2, Juli 1991 NEW YORK US, Seiten 269-270, XP 000211105 'interconnect fabrication by local metal oxidation'
- EXTENDED ABSTRACTS, Bd. 86-1, Nr. 1, Mai 1986 PRINCETON, NEW JERSEY US, Seiten 385-386, T. YANAI ET AL. 'enhanced oxidation of cvd tungsten silicide'
- JOURNAL OF VACUUM SCIENCE AND TECHNOLOGY: PART B, Bd. 3, Nr. 4, 7.August 1985 NEW YORK US, Seiten 992-996, T.YACHI ET A.USE OF TISI2 TO FORM METAL-OXIDE SILICON FIELD EFFECT TRANSISTORS WT.YACHI ET AL. 'use of TiSi2 to form metal-oxide -silicon field effect transistors with self-aligned source/drain and gate electrode.'
- JOURNAL OF CRYSTAL GROWTH, Bd. 11, Nr. 1/4, Mai 1991 AMSTERDAM NL, Seiten 957-960, XP 000298477 M. MIYAO ET AL. 'characterization and application of fine-patterned Si/CoSi2/Si double heterostructures fabricated by self-aligned two-step MBE.'
- THIN SOLID FILMS, Bd. 140, Nr. 1, 16.Juni 1986 LAUSANNE CH, Seiten 115-129, H.JIANG ET AL. 'thermal oxidation of transition metals '
- APPLIED PHYSICS LETTERS, Bd. 67, Nr. 23, 4.Dezember 1995 NEW YORK US, Seiten 3459-3461, XP 000568051 S. MANTI ET A.
- 'Fabrication of vias....' IBM TECHN. DISCLOSURE BULLETIN Bd. 21, Nr. 12, Mai 1979, Seiten 5051 - 5052

## Beschreibung

Die Erfindung betrifft ein Verfahren zur Herstellung einer Schichtstruktur gemäß dem Oberbegriff des Anspruchs 1.

Für zahlreiche Anwendungen im Bereich der Mikroelektronik gewinnen solche Schichtstrukturen mit insbesondere in Silicium vergrabener, metallisch leitender oder halbleitender Struktur zunehmend an Bedeutung. Für die Realisierung beispielsweise von vergrabenen Interconnects gibt es bislang keine geeignete Schichtstrukturen und darauf gerichtete Herstellungsverfahren.

Als Stand der Technik ist ein Verfahren bekannt, bei dem als wesentliche Schritte das lithographische Strukturieren und Ätzen von Gräben in Silicium, die - ggfs. selektive - Abscheidung eines Metalls, das Auffüllen der Gräben mit z.B. SiO₂ und Entfernen des überschüssig abgeschiedenen Materials zu nennen sind.

Dieses Verfahren ist sehr aufwendig und vor allem bei sub-µm Strukturgrößen äußerst problematisch. Desweiteren ist bei diesem Verfahren die Gefahr der Kontamination der Metall/Silicium Grenzflächen durch unerwünschte Kantenbedeckung unvermeidlich. Die Herstellung von epitaktischen Schichten ist damit nicht möglich.

Im Bereich der Mikroelektronik sind aus "Silicides and Contacts for ULSI" in Handbook of Multilevel Metallization for Integrated Circuits, Herausgeb. S.R. Wilson und C. J. Tracy, Noyes Publications, S 32 - 96, 1993 als Stand der Technik zwei Silicide, TiSi₂ und CoSi₂, die für Schichtstrukturen, insbesondere für die Metallisierung von Source, Gate und Drain von Metalloxid-Feldeffekttransistoren (MOSFET) Verwendung werden können, bekannt. Beide Silicide erlauben ein selbstjustierendes Verfahren bei der Silicidbildung und zeichnen sich durch einen kleinen elektrischen Widerstand von ca. 15 µOhmcm aus. Flache p⁺/n Übergänge mit epitaktischen CoSi₂-Schichten sind im Vergleich zu polykristalliner Metallisierung vorteilhaft. Aus Appl. Phys. Lett. 58, S 1308 -1310, 1991 ist bekannt, einkristalline CoSi₂-Schichten mit dem sogenannten Ti-Co-Prozeß durch Sputterdeposition und Tempern herzustellen.

Einkristalline CoSi₂-Schichten zeichnen sich gegenüber polykristallinen Siliciden durch eine wesentlich höhere thermische Stabilität aus: einkristalline CoSi₂-Schichten, insbesonders wenn sie in Silicium vergrabenen sind, sind stabil bis ca. 1200°C.

Jedoch sind die erwähnten bekannten Verfahren gerade für die Siliciden nicht zur Herstellung von Schichtstrukturen geeignet, da sowohl Kontaminationen als auch eine qualitativ ungenügende Passivierung dabei unüberwindbaren Probleme bereiten.

Es ist deshalb Aufgabe der Erfindung, eine Schichtstruktur der eingangs genannten Art zu realisieren, die einen Einsatz zur Herstellung von Bauelementen im Bereich der Silicium-Technologie ermöglicht und die im Stand der Technik auftretenden Nachteile verhindert, zumindest erheblich mindert. Es ist weiter Aufgabe der Erfindung ein Herstellungsverfahren für solche Schichtstrukturen bereitzustellen, das diese Nachteile nicht aufweist.

Eine weitere Aufgabe der Erfindung ist es, ein eine solche Schichtstruktur enthaltendes Bauelement zu schaffen, das im Bereich der Siliciumtechnologie Einsatz finden kann.

Die Aufgabe wird gelöst durch ein Verfahren gemäß der Gesamtheit der Merkmale des Anspruchs 1. Weitere Ausgestaltungen dieser Lehren finden sich in den auf jeweils einer dieser rückbezogenen Ansprüchen 2 bis 6.

Es wurde erkannt, z.B. aus IBM Technical Disclosure Bulletin, Bd. 21, Nummer 12, Seiten 5051-5052 (Mai 1979), daß bei lokaler Oxidation einer Silicid-Schicht diese dort von seiner Grenzfläche aus in die Silicid-Schicht hinein zu SiO₂ oxidiert. Zudem wurde aber auch erkannt, daß dabei gleichzeitig auf der dieser Silicid-Grenzfläche gegenüberliegenden mit der Siliciumhaltigen Oberfläche bzw. Substratoberfläche verbundenen Grenzfläche das Silicid während der lokalen Oxidation in das Silicium hineinwächst.

Im Ergebnis erhält man auf diese Weise sehr überraschend ein im Bereich der lokalen Oxidation in die Tiefe der Schicht hinein versetzter Teil der Silicid-Schicht. Diese Schichtstruktur weist dabei im versetzten Bereich der so gewellten Silicid-Schicht sehr überraschend die gleiche Schichtform, insbesondere soweit es die Kristallqualität als auch die Beibehaltung der Planarität der Schicht betrifft, auf.

Zwar ist die lokale Oxidation von Silicium als solche bekannt und wird sie standardmäßig zur Isolation benachbarter Bauelemente bei hoch und höchstintegrierten Schaltkreisen eingesetzt (Stanley Wolf, "Silicon Processing for the VLSI Era, Vol. 2, Process Integration," Lattice Press, Sunset Beach, CA, 1990).

Dabei wächst während des Oxidierens SiO₂ an den nicht mit Oxidationsmaske abgedeckten Stellen in das Siliciumsubstrat hinein und bildet an diesen Stellen auf diese Weise lokal eine elektrisch isolierende SiO₂-Schicht. Darin erschöpfte sich jedoch der bisher bekannte Wirkungsgehalt der lokalen Oxidation.

Es wurde zur vorliegenden Erfindung zudem erkannt, daß bei fortdauernder Oxidation sich der betreffende Schichtbereich in die Tiefe zunehmend versetzt ausbildet gegenüber den benachbarten Schichtbereichen.

Besonders vorteilhaft wird das Verfahren gemäß Anspruch 1, wenn so lange oxidiert wird, daß der lokal versetzte Schichtbereich schließlich von den ihn benachbarten Schichtbereichen abreißt und auf diese Weise ein getrennter Schichtbereich unter Beibehaltung der Schichteigenschaften bildet. Dabei kann z.B. durch geeignete Wahl der Dauer der Fortsetzung der lokalen Oxidation nach dem Trennungvorgang die Entfernung der sich benachbarten Schichtbereiche in Richtung des Oxidationsprozeß gezielt eingestellt werden.

Sehr vorteilhaft wird das Herstellungsverfahren, wenn gemäß der Gesamtheit der Merkmale des Anspruchs 2 verfahren wird: wenn vor der lokalen Oxidation die Silicidschicht durch Aufbringung und Bildung einer oder mehrerer, weiteren Schichten als teils oder ganz im Silicium vergrabene Schicht vorliegt und sodann lokal oxidiert wird.

In diesem Falle wird zunächst die darüberliegende Schicht oder die darüberliegenden Schichten oxidiert. Schließlich ist der Oxidationsprozeß soweit fortgeschritten, daß er die Silicid-Schicht erreicht hat und nunmehr die lokale Oxidation dieser Schicht erfolgt, insbesondere steuerbar über die Zeitdauer des Oxidationsprozeß.

Die lokale Oxidation erfolgt in oxidierender Atmosphäre durch lokale Deponie ausreichender Energie an der gewünschten Stelle der Schichtstruktur. Dabei ist es vorstellbar z.B. mit einem lokal stark begrenzten Lichtbündel beispielsweise eines Lasers den lokalen Bereich der zu oxidierenden Schichtstruktur festzulegen und bei ausreichender Energieleistung des Lasers auf diese Weise die Schicht lokal zu oxidieren.

Eine zweckmäßige Variante des erfindungsgemäßen Verfahrens sieht gemäß Anspruch 3 den Einsatz einer auf der Silicid-Schicht gebildeten Maske vor. Die Energie kann dann durch thermische Behandlung in einem Ofen erfolgen. Dabei kann die Maske auf die in Anspruch 4 näher formulierten Weise ausgebildet sein. Zwar kann dabei das SiO₂ zur Bildung der zur lokalen Oxidation vorgesehenen Bereiche strukturiert werden. Alternativ kann von dieser Maßnahme aber auch abgesehen werden; auf diese Weise kann die SiO₂-Schicht als Ätzstopp Verwendung finden. Für die lokale Oxidation der Silicid-Schicht ist diese Wahl der Strukturierung im wesentlichen unerheblich, weil eine ggfs. vorhandene SiO₂-Schicht den Anfang der in die Silicid-Schicht hineinwachsenden Oxidationsprozeß dieser Schicht bildet.

Die Silicid-Schicht kann polykristallin ausgebildet sein. Es ist für bestimmte Zielsetzungen gemäß Anspruch 5 zweckmäßig, sie einkristallin auszubilden. Soweit als Silicid ein metallisch leitendes Material, insbesondere CoSi₂, gewählt wird, kann auf diese Weise z.B. eine Interkonnektstruktur in Silicium gebildet werden. Zu anderen Zwecken mag es günstig sein ein halbleitendes Silicid zu wählen.

Besonders vorteilhaft wird das Verfahren, wenn die lokale Oxidation mehrmals und wenigstens zum Teil an anderen Stellen der Schichtstruktur durchgeführt wird. Auf diese Weise erhält man vergrabene Silicid-Strukturen in mehreren unterschiedlichen Ebenen des Siliciumhaltigen Materials bzw. des Substrats auf Silicium-Basis.

Damit kann man individuellen Anforderungen entsprechend dreidimensionale, leitende und/oder halbleitende Silicidstrukturen in der Schichtstruktur herstellen oder im Falle bereits hergestellter Strukturen diese neu strukturieren, zur Herstellung geeigneter Strukturen oder Bauelemente.

Vergrabene Silicidschichten, auch in Verbindung mit Oberflächensilicidschicht, können durch lokale Oxidation mit Hilfe des erfindungsgemäßen Verfahrens strukturiert werden. Erreicht das lokale Oxid (Silicid mit Oxid) das vergrabene Silicid wird dieses zunächst verformt, verschoben und schließlich von der ürsprünglichen Schicht separiert. Dadurch kann eine vergrabene Silicidschicht lokal strukuriert werden.

In sehr vorteilhafter Weise kann das in der Schichtstruktur vorhandene Silicium in einem räumlich begrenzten Bereich z.B. mit Hilfe der Ionenimplantation p- oder n-dotiert werden. Insbesondere kann dabei der Bereich unterhalb einer vergrabenen Silicid-Schicht mit Ionen implantiert und auf diese Weise das Silicium definiert dotiert werden.

Schließlich ist es vorteilhaft als Silicium-haltige Oberfläche (1) die Oberfläche eines Silicium-Substrats (1) mit der Kristallorientierung (1-0-0) zu wählen.

Die Silicidschicht kann vor der lokalen Oxidation lithographisch strukturiert werden, so daß nach dem Oxidationsprozeß nur noch vergrabene Silicidschichten an den ursprünglich silicidierten Bereichen vorliegen. Dies eröffnet die Möglichkeit, planare Isolation und vergrabene Silicidschichten (z.B. vergrabene Metallisierung für Interconnects) in einem Prozeßschritt (eine thermische Oxidation mit gleicher Maske) durchführen zu können.

Zur Durchführung der lokalen Oxidation kann eine Temperung in Sauerstoff oder Wasserdampf erfolgen. Es ist aber auch vorstellbar diesbezüglich ein Gasgemisch einzusetzen, wie zum Beispiel ein Sauerstoff-Stickstoffgemisch. Auf diese Weise kann eine spezielle Art der lokalen Oxidation, nämlich eine Oxyd-Nitrid-Bildung erfolgen, die für manche Anwendungen an Stelle der "einfachen" lokalen Oxidation ebenfalls erwünscht sein kann. Im übrigen kann es beispielsweise zur Reduzierung der thermischen Belastung zweckmäßig sein, die lokale Oxidation unter erhöhtem Gasdrück, zum Beispiel Sauerstoff in einer Hochdruckanlage durchzuführen. Durch die Wahl eines geeigneten Gasgemisches und / oder eines erhöhten Gasdrucks kann die Qualität der Schichtstruktur und des Herstellungsverfahrens weiter gesteigert werden.

Die Wahl des Materials für das Substrat auf Silicium-Basis kann je nach bedarf unterschiedlich gewählt werden. Besonders aufzuführen sind:
- Epi-Silicium Scheiben, mit verschieden Dotierungsschichten und Dotierungsstrukturen,
- Si-Legierungsschichten, z. B. vergrabene Si₁₋ₓ-Geₓ, Si-C,
- SOI (silicon on insulator, z.B. SIMOX, BESOI; Si on Saphire),
- SOM (silicon on metal) Substrate
   (z.B. vergrabene CoSi₂-Schicht in Silicium).

Insgesamt weisen das erfindungsgemäße Verfahren und die so hergestellte Schichtstruktur folgende Merkmale auf:

Beide, in der Tiefe versetzten Schichten sind nur über das sie umgebende Silcium verbunden. Handelt es sich bei dem verwendeten Silicid um ein Metall, z.B. CoSi₂, dann sind dadurch zwei elektrisch voneinander getrennte Metallisierungsebenen entstanden, bei gleichzeitiger herausragender Passivierung der Silicidstruktur.

Das durch die lokale Oxidation strukturierte Silicid und Silicium bilden bei Verwendung eines metallischen Silicides metallisierte und durch SiO₂ passivierte Mesastrukturen, die Bausteine für insbesondere vertikale Bauelemente sind. Bei Bedarf kann neben dem Siliciumnitrid auch das Siliciumoxid leicht selektiv entfernt werden, so daß freistehende MESA-Strukturen entstehen.

Nach Entfernen des Siliciumnitrides kann durch eine nachträgliche Dotierung des Siliciums unterhalb der Oberflächenmetallisierung z.B. durch Niederenergie-Implantation in oder durch das Silicid z.B. ein ohmscher Kontakt erzeugt werden. Dieser Prozeß kann ohne weitere Maske durchgeführt werden, da eine Dotierung des SiO₂ nahe der Oberfläche, die Isolationseigenschaften nicht beeinflußt.

Erfolgt die Implantation in das Silicid, kann durch Tempern eine Ausdiffusion des Dotierstoffes z.B. aus CoSi₂ erzielt und dadurch eine sehr flache Dotierung erreicht werden. Eine laterale Ausdiffusion - eine sonst häufiges Problem - ist aufgrund der seitlichen SiO₂-Begrenzung des Silicids ausgeschlossen (siehe erstes Ausführungsbeispiel).

Insgesamt weist das Verfahren folgende, sich auch auf die Schichtstruktur auswirkende Vorteile auf:
- selbstjustierend,
- wenige, einfache Prozeßschritte,
- mäßige thermische Belastung insbesonder im Falle einer Naßoxidation (small thermal budget).

Die Schichtstrukturen sind äußerst hochtemperaturstabil (je nach Material und Schichtdicke (z.B. 100 nm dickes CoSi₂ über 1100°C)), sodaß weitere Prozesse bei hohen Temperaturen zur weiteren Ausbildung der Schichtstruktur möglich sind. Aufgrund des besonderen, "inneren" Wachstumsprozesses ist eine Kontamination der Grenzflächen (Silicid-Silicium, SiO₂/Silicium) ausgeschlossen und ist die Herstellung einkristalliner, vergrabener Silicidstrukturen mit herausragender Qualität damit möglich.

Soweit als Silicidschicht eine metallisch leitende Oberflächenschicht gewählt wird, können aus einer einzigen solchen Oberfläschenmetallisierung auf diese Weise zwei oder bei wiederholter Anwendung mehrere Metallisierungsebenen erhalten werden.

Außerdem ist damit ein vielseitiges Strukturierungsverfahren für Silicide gegeben; die Strukturen kann makroskopisch groß (z.B. bezogen auf eine Siliciumscheibe) sein oder weit im sub-µm Bereich liegen. Dies ist umso bedeutender, da sich die beiden wichtigen Silicide, CoSi₂ und NiSi₂, nicht mit reaktivem Ionenätzen strukturieren lassen, da es keine leichtflüchtigen Verbindungen von Co und Ni mit F oder Cl bei Raumtemperatur gibt.

Anwendungsmöglichkeiten des erfindungsgemäßen Verfahrens finden sich im Bereich der Herstellung von vertikalen Transistoren, wie z.B. LOCOS-PBT, vertikaler MOSFET, quasi-vertikaler Leistungs-FET. Aber auch im Bereich der Kontaktierung von vergrabenen Dotierungschichten (buried layers), in der Mikrosystemtechnik, z.B. Entwicklung neuer Sensoren oder bei Höchstfrequenz-Metallisierungsstrukturen (koplanar und Mikrostripline-Technologie), Photodetektotoren, optische Wellenleiter auf Siliciumbasis, Einkoppelelemente für Wellenleiter oder Modulatoren kann das Verfahren bzw. die Schichtstruktur eingesetzt und Verwendung finden.

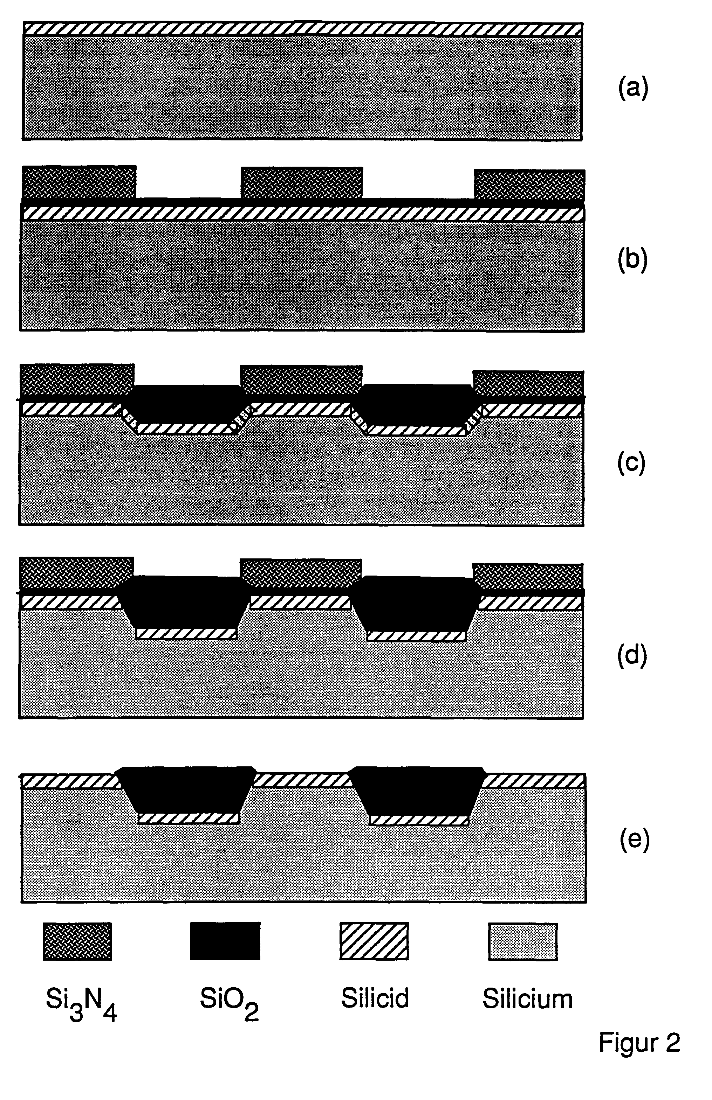

Im folgenden wird die Erfindung an Hand von Ausführungsbeispielen und Figuren in schematischer Darstellung näher erläutert. Es zeigen
- Fig. 1: Oberflächen- und vergrabene Metallisierungsebene mit einem Silicid sowie lokale elektrische Isolation durch SiO₂ von Bereich II und Bereich III. I und II sind durch vergrabenen Interconnect verbunden,
(a) Silicium Epi-schicht auf hochohmigem Wafer,
(b) Silicium Epi-schicht auf SOI-Substrat;
- Fig. 2: Schematische Darstellung der einzelnen Verfahrensschritte des erfindungsgemäßen Verfahrens:
(a) Silicidschicht auf Silicium-Substrat,
(b) Oxidationsmaske, bestehend aus SiO₂- und Si₃N₄-Schicht für die lokale Oxidation,
(c) Siliciumdioxidbildung auf der Silicidschicht an den nicht abgedeckten Stellen;lokale Verschiebung der Silicidschicht Richtung Substrat,
(d) Silicidschicht ist durch fortschreitende Oxidation in mehreren in unterschiedlichen Ebenen gelegenen Bereichen getrennt;

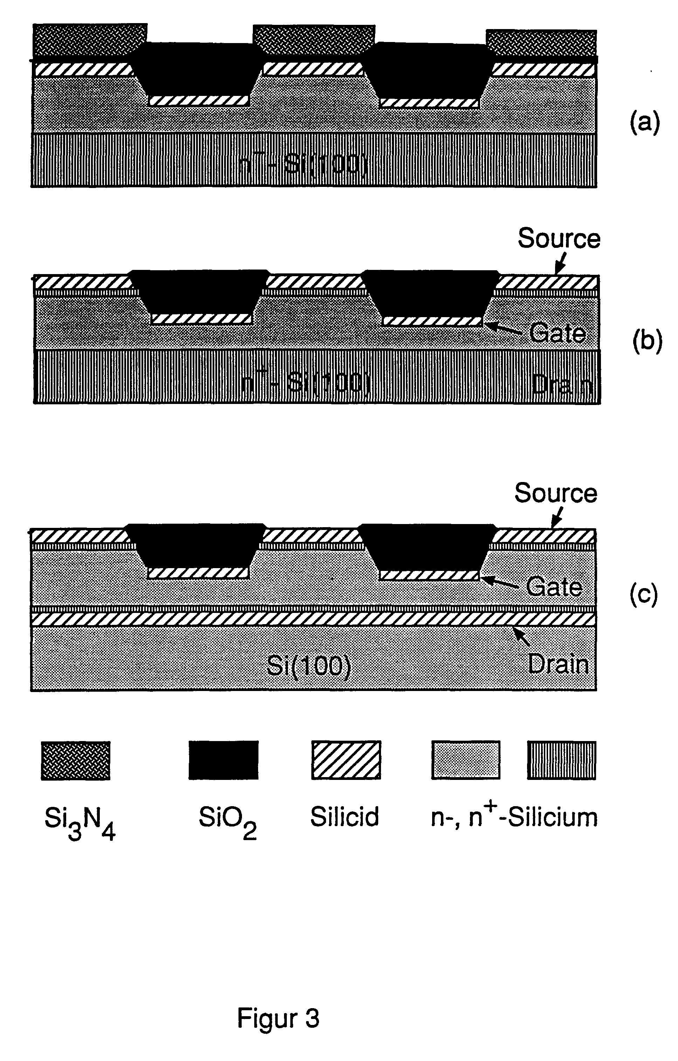

- Fig. 3: Herstellungsverfahren eines Kurzkanal PBT's mit Hilfe des erfindungsgemäßem Verfahrens:
(a) Modifikation desAufbaus gemäß Fig. 2d hier auf n⁺-Si(100) mit n-Epi-Schicht,
(b) Aufbau des Kurzkanal-PBT's,
(c) Kurzkanal PBT mit zusätzlicher, vergrabener Silicidschicht;

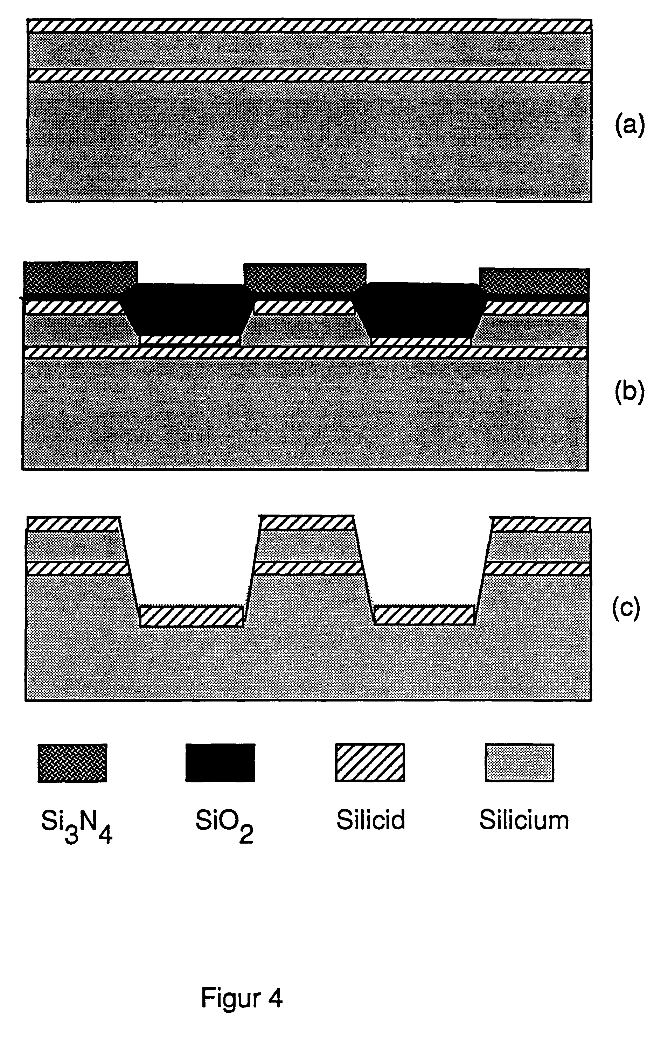

- Fig. 4: Strukturierung einer vergrabenen Silicidschicht:
(a) Siliciddoppelschicht,
(b) Struktur nach teilweiser Durchführung der lokalen Oxidation,
(c) Struktur nach Beendigung der lokalen Oxidation;

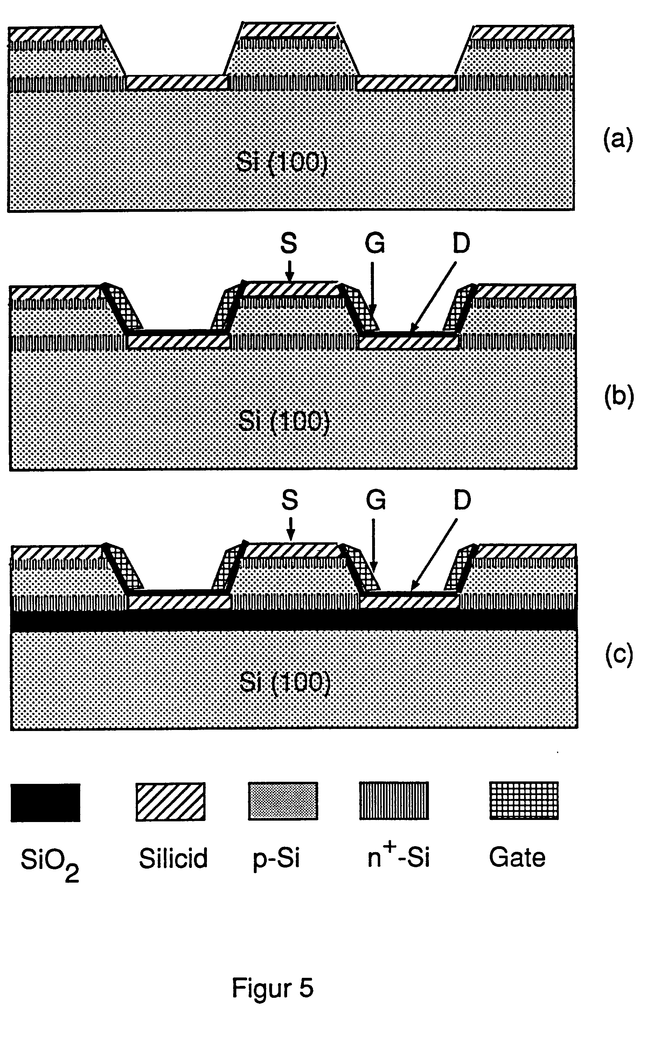

- Fig. 5: Herstellung eines vertikalen MOSFET:
(a) mit Hilfe des erfindungsgemäßen Verfahren erhaltene MESA-Strukturen nach Entfernung der Oxidationsmaske,
(b) vertikale MOSFET-Struktur mit Kontaktierung (S bezeichnet Source (Quelle), G Gate (Steuerelektrode) und D Drain (Senke),
(c) vertikaler MOSFET auf SOI-Substrat;

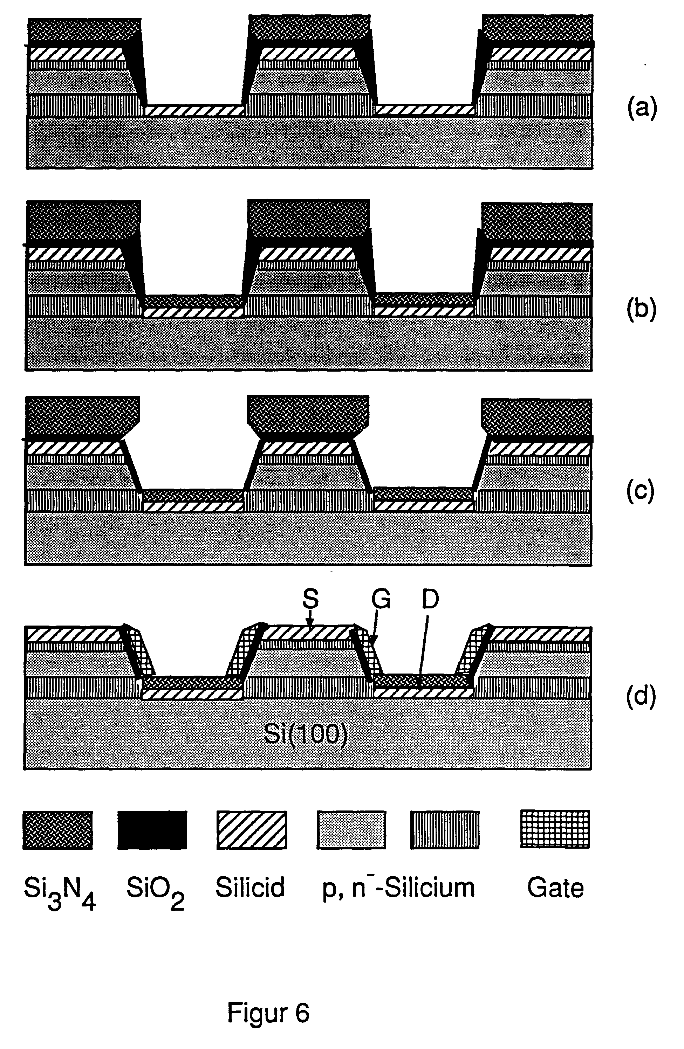

- Fig. 6: Zu Fig. 5 alternatives Herstellungsverfahren für vertikalen MOSFET:
(a) verfahrensmäßig erhaltene MESA-Struktur nach partiellem Entfernen des Oxids durch Trockenätzen,
(b) Struktur nach Abscheidung einer Nitridschicht (wahlweise),
(c) Struktur nach naßchemischer Entfernung des Oxids und thermischer Gate-Oxidbildung,
(d) vertikaler MOSFET nach Abscheidung der Gate-Kontakte und Entfernung der Nitridmaske (S bezeichnet Source, G Gate und D Drain);

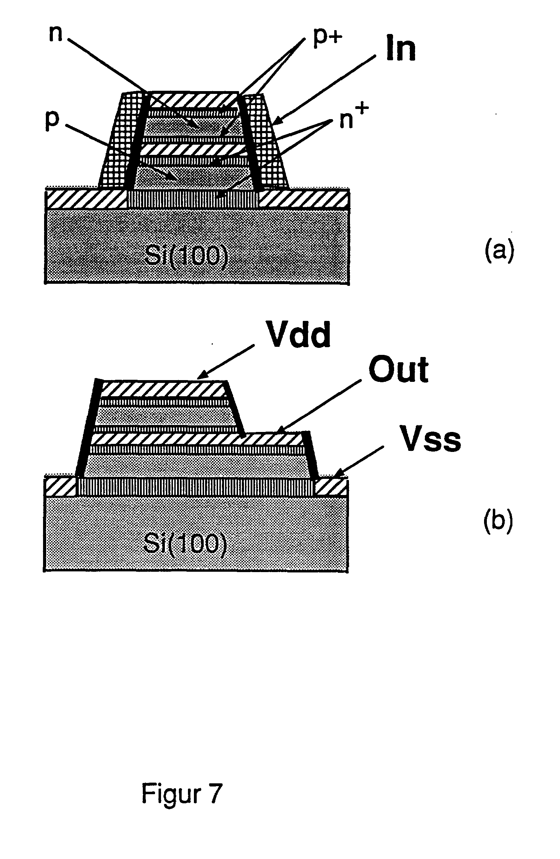

- Fig. 7: Schematischer Aufbau eines vertikalen Inverters mit Silicidzwischenschicht (Schraffur wie Figur 6); IN und OUT bezeichnen den Eingang und den Ausgang, Vdd und Vss die Kontakte für Drain (Quelle) und Source (Senke):
(a) Aufbau der Silicium-Dotierungsschichten zwischen den Silicidschichten für den n- und p-Kanal MOSFET,
(b) Seitenansicht;

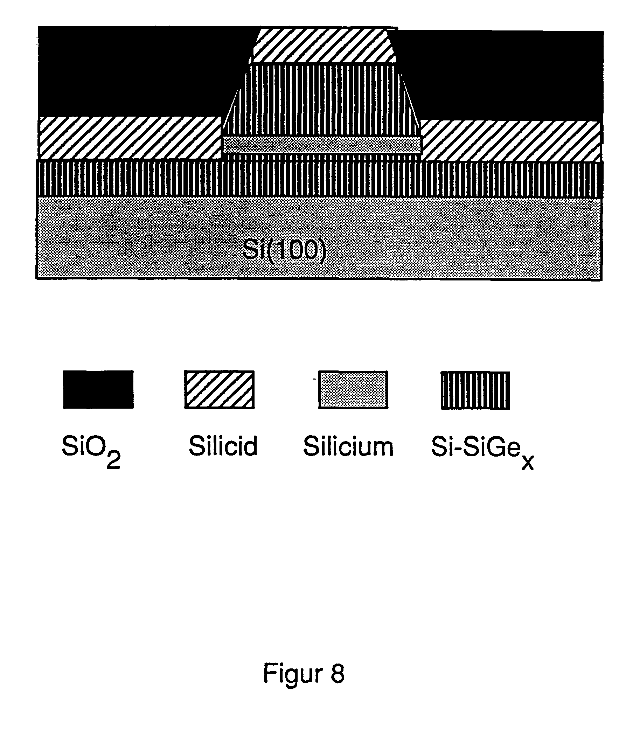

- Fig. 8: Herstellung der MESA-Struktur und der Metallisierung von Si-Ge-MODFETs. Die mit Si- SiGeₓ gekennzeichneten Schichten bestehen aus verschiedenen Si- und Si-Ge-Schichten unterschiedlichen Germaniumgehaltes. Die tieferliegende Silicidschicht kontaktiert den Kanal des MODFET's;

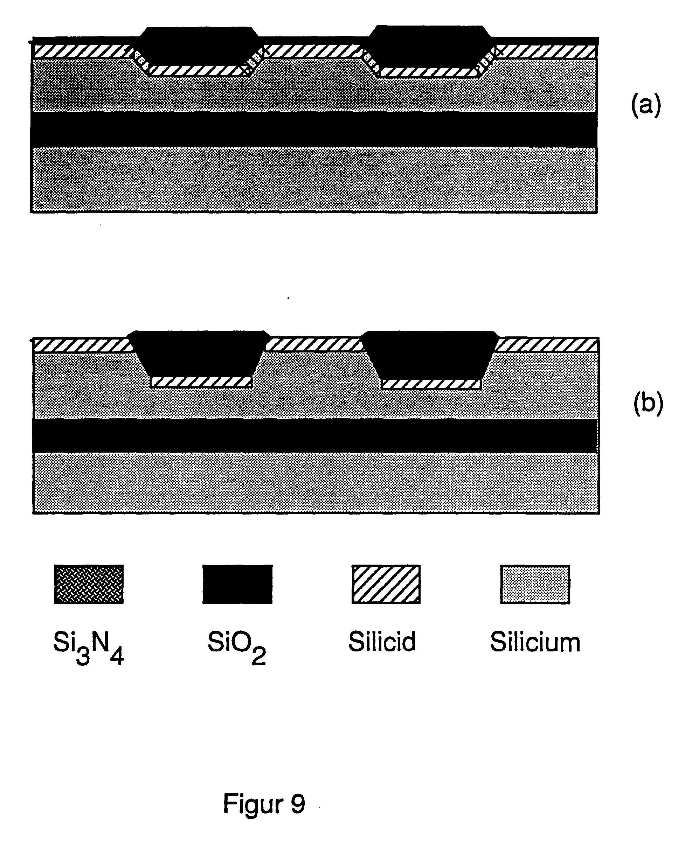

- Fig. 9: Ausschnitt aus Silicidgitter zur Phasenmodulation in Silicium-Wellenleiter auf SOI:
(a) zusammenhängende Silicidstruktur mit Tiefenvariation,
(b) periodisches Silicidgitter (schematisch);

### Ausführungsbeispiel 1 (Figur 2)

Auf ein Siliciumsubstrat 1 wurde zunächst eine Silicid-Oberflächenschicht 2 abgeschieden. Die Silicidschicht 2 war metallisch (z.B. CoSi₂), aber könnte auch halbleitend (z.B. β-FeSi₂) sein, bevorzugt aber von guter Planarität und Morphologie (Fig.2a). Am besten eigneten sich epitaktische Schichten, mit hoher Planarität und geringer Grenzflächenrauhigkeit, da sie eine höhere thermische Stabilität aufweisen.

Anschließend wurde ein dünne SiO₂-Schicht 4 (ca. 10 nm dick) z. B. durch thermisches Oxidieren (z.B. Trockenoxidation im RTA) erzeugt, auf die eine wesentlich dikkere Si₃N₄-Schicht 5 (typischerweise > 50 nm, z.B. 150 nm) aufgebracht wird. Die Si₃N₄-Schicht 5 wurde anschließend durch Trockenätzen strukturiert (Fig. 2b). Von untergeordneter Bedeutung ist es, ob die SiO₂ Schicht an den freigeätzten Stellen mitabgeätzt wird oder als Ätzstop benutzt wird.

Es folgte nun die thermische Oxidation der strukturierten Schichtenstruktur. Die Oxidation kann sowohl naß als auch trocken erfolgen. Wenn sehr hohe Temperaturen vermieden werden sollen, ist Naßoxidation vorzuziehen. Während der Oxidation bildete sich eine SiO₂-Schicht auf dem Silicid 2 und die Silicidschicht 2 wurde an den nicht mit Nitrid 5 abgedeckten Stellen förmlich in das Silicium 1 hineingeschoben. Dadurch verformte sich die ursprünglich planare Silicidschicht 2 an den Übergangstellen zwischen den oxidierten und nichtoxidierten Bereichen, wie in Fig. 2c gezeigt.

Die Silicidschicht 2 blieb aber zunächst zusammenhängend und behielt - abgesehen von den sehr schmalen Übergangsbereichen - ihre Planarität. Dadurch wurde die Möglichkeit geschaffen, aus einer planaren Oberflächenschicht eine in der Tiefe variierende, wellenförmige Silicidschicht einfach herzustellen.

Mit fortschreitender Oxidation wurde die Silicidschicht 2 tiefer in das Silicium 1 hinein geschoben und führte zu einem ganz besonderen Effekt: Bei einer kritischen Oxidationstiefe (abhängig von Silicid, Silicidschichtdicke und Prozeßführung) riß die Silicidschicht 2 genau an den Übergangsbereichen, wie in Fig. 2d gezeigt. Wesentlich dabei ist, daß die Schicht auch unterhalb des Oxides planar und zusammenhängend blieb. Die Schichtdicke des Silicides an den oxidierten Stellen hatte, bedingt durch diffusive Umverteilung, um ca. 20% abgenommen.

Das Abreißen der Silcidschicht 2 könnte auch durch eine thermische Behandlung, z.B. durch Kurzzeittempern einer bereits lokal oxidierten aber noch zusammenhängenden Silicidschicht 2 bereits bei kleinen SiO₂-Schichtdicken erreicht werden (z.B. RTA bei 1000°C, 60s bei einer Co-Si₂-Schicht mit einer Dicke von ca. 70 nm).

Nach Entfernen der Nitridschicht 5 und des Oberflächenoxids (z.B. durch Trockenätzen) entsteht die in Fig. 2e dargestellte, nahezu planare Struktur mit den beiden getrennten Silicidebenen.

### Ausführungsbeispiel 2 (Figur 3)

### Verfahren zur Herstellung eines LOCOS- Permeable Base Transistors (PBT) mit kurzem Kanal

Auf einen hochdotierten n-Si(100) Wafer wurde eine Silicium -Epi Schicht 1 mit einer Dotierung von 1 - 100*10¹⁵ cm⁻³ und einer Dicke von ca. 200 bis 500 nm aufgebracht. Anschließend wurde eine CoSi₂-Schicht 2 (ca 30 bis 100 nm) abgeschieden. Am geeignetsten erscheinen, insbesondere für sehr kleine Strukturen (submicron) epitaktische CoSi₂-Schichten 2, die mittels des sogenannten Co-Ti-Prozesses, der Molekularstrahlepitaxie, der Molekularstrahl-Allotaxie oder durch Ionenstrahlsynthese hergestellt werden können.

Zur Durchführung der lokalen Oxidation wurde eine dünne ca. 10 nm dicke SiO₂-Schicht 4 und eine einige 100 nm dicke Si₃N₄-Schicht 5 abgeschieden (vergleichbar wie in Fig. 2b). Durch 45-minütige lokale Naßoxidation bei 850°C konnte eine ca. 300 nm dicke SiO₂-Schicht auf der CoSi₂-Schicht 2 erzeugt werden (Fig. 3a). Um ein sicheres Abreißen der Silicidschicht an den Übergangstellen zu gewährleisten könnte die Probe thermisch nachbehandelt werden (z.B. 1000°C, 60s bei 70 nm CoSi₂). Die Temperbedingungen sollten den Schichtdicken des Silicides und des Oxides angepaßt werden.

Anschließend wurden das Siliciumnitrid 5 und an den Sourcekontaktstellen das SiO₂ entfernt. Zur Herstellung eines ohmschen Sourcekontaktes wurde eine flächenhafte Implantation eingesetzt (Fig. 3b). Dabei störte die flache Implantation in das SiO₂ das elektrische Isolationsverhalten des SiO₂ nicht. Diese implantierte Dotierung kann anschließend durch thermische Behandlung aktiviert oder für besonders flache Kontakte auch aus dem Silicid ausdiffundiert und aktiviert werden. Diese thermische Behandlung kann auch zum gezielten Abreißen der Silicidschichten (s.o.) eingesetzt werden.

Für die elektrische Kontaktierung des Gates muß das tieferliegende Silicid an den Kontaktstellen durch Trockenätzen (RIE) freigelegt werden. Der Drainkontakt kann an der Waferrückseite oder durch ein Kontaktloch zum hochdotierten Wafer realisiert werden. Fig. 3 b zeigt schematisch den Aufbau eines Kurzkanal PBTs mit vergrabenem metallische Gate, das lokal mit Siliciumoxid abgedeckt ist.

Anstelle eines n⁺-Wafers mit einer Epi-Schicht kann für Hochfrequenzanwendungen alternativ auch eine vergrabene n⁺-Schicht in einem n⁻-Si(100) Wafer Verwendung finden. Alternativ zu einem hochdotierten Si-Wafer kann auch ein SOI (SIMOX oder BESOI) Wafer passender Dotierung (mit Dotierungswanne) verwendet werden. Eine weitere Alternative ist die Verwendung von Siliciddoppelschichten. Dabei wird der Drainkontakt durch die tieferliegende Silicidschicht, die an der Oberseite hochdotiertes Silicium für einen guten ohmschen Kontakt aufweist, ausgeführt (Fig. 3c).

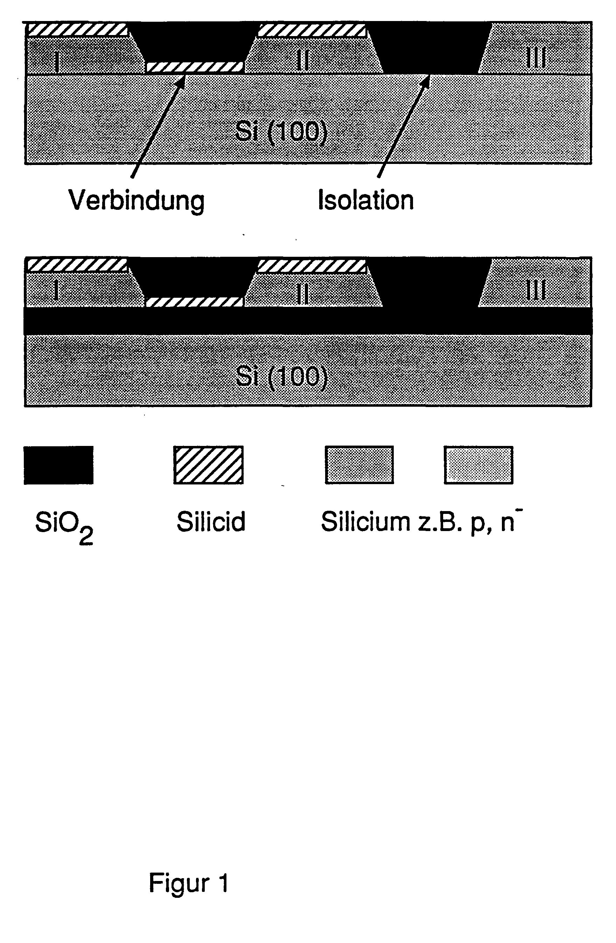

### Ausführungsbeispiel 3 (Figur 1)

Herstellung vergrabener Interconnects und elektrischer Isolation zwischen elektronischen Bauelementen durch LOCOSI und LOCOS

Die Standard LOCOS-Technologie zur lateralen Isolation von integrierten Bauelementen kann in einem Schritt (oder aufeinanderfolgend) mit dem erfindungsgemäßen LOCOSI-Verfahren durchgeführt werden. Ausgehend von einem nur teilweise silicidierten Wafer 1 wird durch die Verwendung der üblichen Oxidationsmasken 3 lokale Oxidation durchgeführt.

An den silicidierten Stellen entstehen durch die Oxidation vergrabene elektrische Verbindungen 2 (Interconnects), während an den nur oxidierten Bereichen 2 elektrische Isolation erzielt wird (Fig. 1). Diese Anwendung ist insbesondere bei der Wahl eines SOI-Wafers vorteilhaft, da die Silicidschicht 2 bzw. das lokale Oxid durch geeignete Wahl der Prozeßparameter bis an den Isolator des SOI-Wafers (z.B. SiO₂, Saphire) herangeführt werden kann (Fig. 1b) und dadurch störende Substrateinflüsse völlig ausgeschaltet werden können.

### Ausführungsbeispiel 4 (Figur 4)

### Strukturierung einer vergrabenen Silicidschicht

Der LOCOSI Prozeß kann auch zur Strukturierung einer vergrabenen Silicidschicht 2 mit oder ohne Silicidoberflächenschicht eingesetzt werden (Fig. 4a). Dadurch wird die Realisierung neuer dreidimensionaler Strukturen möglich. Eine vergrabene, einkristalline Silicidschicht 2 kann nur mit speziellen Verfahren in Silicium mit (100) Orientierung hergestellt werden. Besonders geeignet sind die Ionenstrahlsynthese (A.E. White et al., Appl. Phys. Lett. 50, S 95-97, 1987) und die Molekularstrahl-Allotaxie (Mantl und H. L. Bay, Appl. Phys. Lett. 61, S 267-269,1992). Wie bereits in Fig. 2 gezeigt, wird zuerst eine Oxidationsmaske 3 erzeugt. Anschließend wird die Probe oxidiert. Sobald das Oxid die vergrabene Silicidschicht 2 erreicht, verschiebt sich diese tiefer in das Substrat 1, ähnlich wie in Fig. 2c.

Fortschreitende Oxidation führt wie bei Oberflächenschichten 2 zu einem Abreißen der vergrabenen Silicidschicht 2 (Fig. 4b). Auch in diesem Fall kann das gezielte Abreißen der Silicidschicht 2 an den Übergangsbereichen durch ein Tempern - wie oben bereits ausgeführt- erzielt werden. Die Silicidschicht 2 wird durch die Oxidation tiefer in das Substrat 1 hineinverlagert, behält aber ihre Planarität bei.

### Ausführungsbeispiel 5

### Verfahren zur Herstellung eines vertikalen MOSFET

Vertikale MOS-Transistoren sind für zukünftige Höchstintegration von großer Bedeutung, da aufgrund der extrem kurzen Kanallängen sehr hohe Schaltgeschwindigkeiten zu erwarten sind, sie mit Standard Lithographieverfahren herstellbar sind und der Platzbedarf reduziert werden kann. Vertikale MOS-Transistoren stecken noch in den Anfängen ihrer technologischen Entwicklung. Wie bereits an Hand der Fig. 2 gezeigt, lassen sich mit Hilfe des LOCOSI Prozesses Silicium Mesastrukturen herstellen, die für die Herstellung eines vertikalen MOS-Transistors genutzt werden können. Das Oberflächensilicid 2 bildet dabei bereits den Source (Quelle) - und das tieferliegende den Drain (Senke)-Kontakt. Voraussetzung dafür ist die Verwendung von geeignet vordotierten Silicium.

Verwendet man anstelle eines einfachen Si-Wafers einen der bereits mit Dotierungsschichten versehen ist, dann kann die in Fig. 5a beispielhaft dargestellte MESA-Struktur für einen n-MOSFET mit dem LOCOSI Prozeß hergestellt werden, wobei bereits selektiv das Nitrid 5 und das Oxid entfernt wurden. Die Dotierungsschichten im Silicium können dabei durch Standardverfahren, wie z.B. epitaktische Deposition oder Ionenimplantation erzeugt werden. Da die Schichtstruktur einer weiteren Oxidation thermisch stabil ist und damit höheren Temperaturen ausgesetzt werden kann, kann das Gate-Oxid durch thermische Oxidation erzeugt werden.

Für den noch fehlenden Gate-Kontakt wird mit Poly-Silicium und/oder Metall auf das vertikal verlaufende Gateoxid aufgebracht und lithographisch strukturiert (Fig. 5b).

Das beschriebene Verfahren kann auch mit einem Wafer mit einer zusätzlichen, vergrabenen Silicidschicht angewandt werden. Dies führt zu einem Kurzkanal PBT mit besonders niederohmigen Drainkontakt für Leistungs- und Hochfrequenzanwendungen (Fig. 5c).

Eine weitere Alternative der Prozeßführung ist in Fig. 6 dargestellt. Dabei wird das bei dem LOCOSI Verfahren entstandene Oxid durch Trockenätzen nur teilweise entfernt. Dieser Prozeß bedarf keiner neuen Maske, da die Nitridschicht diese Aufgabe erfüllt. Zusätzliche ist das Silicid ein ausgezeichneter Ätzstop. Das verbleibende Oxid kann als Gateoxid verwandt werden, so daß keine weitere Oxidation erforderlich ist. Nach Bedarf kann jetzt auf die Silicidschicht eine Isolationsschicht (z.B. Si₃N₄) abgeschieden werden, um die Gate-Kontaktierung zu erleichtern und die parasitäre Gate-Kapazität zu reduzieren (Fig.6b). Jetzt besteht auch die Möglichkeit das Oxid ganz (oder teilweise) naßchemisch zu entfernen und durch thermische Oxidation ein neues Gateoxid zu bilden. Die Nitridmaske dient anschließend auch zur Abscheidung des Gate-Kontaktmaterials, hochdotiertes Polysilicium und/oder Metall (Fig. 6c). Anschließend wird das Nitrid entfernt. Die prinzipielle Struktur des vertikalen MOSFET's ist in Fig. 6d gezeigt.

### Ausführungsbeispiel 6

### Herstellung eines vertikalen Inverters

Ausgehend von einer vergrabenen und einer Oberflächensilidschicht (wie Fig. 4) mit geeigneten Dotierungsschichten im Silicium können zwei, aufeinanderaufgewachsene, vertikale MOSFETs, für einen vertikalen Inverter hergestellt werden (Fig. 7). Die vergrabene Silicidschicht wird - wie im Ausführungsbeispiel 3 gezeigt - durch lokale Oxidation strukturiert (Fig. 4b). Die Ausführung des Gates kann wie für den vertikalen MOSFET erfolgen. Ein wesentlicher, neuer Punkt dabei ist, daß die Oxidation der MESA-Struktur auch zur seitlichen Oxidation der vergrabenen Silicidschicht führt und so die Gate-Kontakte des n- und des p-Kanal MOS-FET's zusammenhängend ausgeführt werden können. Figur 7 zeigt den schematischen Aufbau eines vertikalen Inverters wie er mit Hilfe des LOCOSI Prozesses hergestellt werden kann. Anstelle der vergrabenen Silicidschicht mit den beiden p⁺ und n⁺ ohmschen Kontakten für Quelle (Source) und Senke (Drain), kann auch eine p⁺/n⁺ Schichtenfolge benutzt werden.

### Ausführungsbeispiel 7

### Verfahren zur Herstellung einer Mesastruktur für Si-Ge-MODFET (gleichzeitige Metallisierung und Passivierung)

Si-Ge basierende MODFETs (modulation doped FET) können mit Hilfe des LOCOSI Prozesses metallisiert und passiviert werden.

Durch Aufbringen einer Silicidschicht (z.B. CoSi₂) auf die Si-SiGeₓ-Si Schichtstruktur und anschließender Durchführung des LOCOSI-Prozesses kann die in Fig. 8 dargestellte Struktur hergestellt werden. Die Silicidschicht wird durch geeignete Wahl ihrer Schichtdicke (ca. 30 bis 150 nm) und der Oxidationsparameter gerade soweit in die Si/SiGeₓ/Si - Schichtstruktur hineinverlagert, daß eine optimale Kontaktierung des Kanals erreicht wird. Wird als Silicid CoSi₂ verwendet, dann wird das Germanium der SiGeₓ-Schicht nicht in das Silicid eingebaut, sondern vor dem Silicid im das Substrat vorweggeschoben. Dadurch bleibt die gute Leitfkähigkeit des Silicides erhalten. Durch Naßoxidation kann die Temperatur niedrig genug gehalten werden (ca. 750 - 850°C), so daß weder eine störende Si-Ge Interdiffusion noch eine wesentliche Ausdiffusion der Dotierung eintritt. Gleichzeitig werden die nicht metallisierten Bereiche durch SiO₂ passiviert. Das SiO₂ im Source- und Drainbereich kann vor der Entfernung des Nitrides durch Trockenätzen entfernt werden, um sodann durch Implantation und thermische Aktivierung ohmsche Source und Drain-Kontakte zu erzielen. Bei der Verwendung von Co-Si₂ lassen sich sehr kleine Kontakwiderstände erreichen, die ein hohes Leistungsvermögen dieser HEMT (high electron mobility transistor) Transistoren erwarten läßt.

### Ausführungsbeispiel 8

### Herstellung von planaren, strukturierten Heterostrukturen wie z.B. Si/halbleitendes Silicid/Si

Durch lokale Oxidation von halbleitenden Silicidschichten auf Si wurden planare, siliciumbasierende Heterostrukturen relativ einfach hergestellt. Die Realisierung kann entsprechend der zur Fig. 2 erläuterten Vorgehensweise erfolgen.

Zunächst wurde eine halbleitende Silicidschicht 2 auf Silicium 1 hergestellt. Aufbringen einer Oxidationsmaske 3 (SiO₂ und Si₃N₄ - wie oben beschrieben) erlaubte sodann die lokale Oxidation des Silicids 2. Wie in Fig. 2 c dargestellt, entstand dadurch in einer bestimmten Tiefe eine planare Silicium/halbleitendes Silicid/Silicium-Heterostruktur.

### Ausführungsbeispiel 9

### Herstellung optischer Wellenleiter

Die vorgestellten Strukturierungsmöglichkeiten erlauben auch die Herstellung von Silicium, Siliciumdioxid oder Silicium-Germanium Wellenleitern. Die in den Fig. 1b dargestellten Si-MESA-Strukturen stellen bei richtiger Dimensionierung (Mikrometer) durch SiO₂ oder durch Silicid begrenzte, planare Si-Wellenleiter dar. Der Indexsprung an den Grenzflächen ermöglicht die Führung des Lichtes im Wellenleiter.

### Ausführungsbeispiel 10

### Herstellung von optischen Modulatoren mit Si oder Si-Ge Wellenleitern

Werden die in den Fig. 2c,e dargestellten Strukturen auf SOI Substraten (z.B. SIMOX) hergestellt, dann können diese auch zur Phasenmodulation des in einem Silicium-Wellenleiter geführten Lichtes eingesetzt werden, wie in Fig. 9 dargestellt.

## Patentansprüche

1. Verfahren zur Herstellung einer Schichtstruktur mit einer Silizid-Schicht, bei dem diese auf der Oberfläche eines Substrates auf Silizium-Basis gebildet wird,
mit den Schritten
- eine Silizid-Schicht wird auf einem Substrat auf Silizium-Basis angeordnet,
- die Silizid-Schicht wird lokal an ihrer Grenzfläche, die der Grenzfläche zum Substrat gegenüberliegt, oxidiert,
wobei ein lokaler Siliziumoxid-Bereich gebildet wird, und wobei von der Grenzfläche zum Substrat aus ein Silizid-Bereich in das Substrat auf Silizium-Basis hinein diffundiert, **dadurch gekennzeichnet daß**
- die Oxidation wird so lange fortgeführt, bis durch die Bildung des lokalen Siliziumoxid-Bereichs eine Trennung von den benachbarten Bereichen der Silizid-Schicht erfolgt, so daß der oberflächige Bereich der Silizid-Schicht von dem tiefen Bereich getrennt wird.

2. Verfahren nach vorhergehendem Anspruch,
**dadurch gekennzeichnet,**
**daß** auf zumindest einem Teil der gegenüberliegenden Grenzfläche der Silizid-Schicht im zur lokalen Oxidation vorgesehenen Bereich vor der lokalen Oxidation wenigstens eine weitere Schicht gebildet wird.

3. Verfahren nach einem der vorhergehenden Ansprüche,
**dadurch gekennzeichnet,**
**daß** vor der lokalen Oxidation ein Teil der Grenzfläche der Silizid-Schicht, die der Grenzfläche zum Substrat auf Silizium Basis gegenüberliegt, mit einer Maske abgedeckt wird.

4. Verfahren nach einem der vorhergehenden Ansprüche,
**dadurch gekennzeichnet**,
deß zur Bildung der Maske auf der gegenüberliegenden, insbesondere freien Grenzfläche der Silizid-Schicht eine SiO₂-Schicht und auf dieser eine Si₃N₄-Schicht gebildet wird und zur Bildung der zur lokalen Oxidation vorgesehenen Bereiche der Silizid-Schicht zumindest die Si₃N₄-Schicht strukturiert wird.

5. Verfahren nach einem der vorhergehenden Ansprüche,
**dadurch gekennzeichnet,**
**daß** die Silizid-Schicht einkristallin ausgebildet wird.

6. Verfahren nach einem der vorhergehenden Ansprüche,
**dadurch gekennzeichnet,**
**daß** nach Beendigung der lokalen Oxidation der Silizid-Schicht die Maske entfernt wird.

## Claims

1. Process for producing a layered structure with a silicide layer, whereby said silicide layer is formed on the surface of a silicon-based substrate, comprising the steps:
- a silicide layer is arranged on the silicon-based substrate;
- the silicide layer is oxidised locally on its boundary surface located opposite the interface with the substrate, a local silicon oxide region being formed and a silicide region being diffused into the silicon-based substrate from the interface with the substrate,
**characterised in that**
- the oxidation is continued until the formation of the local silicon oxide region causes separation from the adjacent regions of the silicide layer, so that the superficial region of the silicide layer is separated from the deep region.

2. Process according to the preceding claim, **characterised in that** prior to the local oxidation at least one further layer is formed on at least a part of the opposite boundary surface of the silicide layer in the area intended for the local oxidation.

3. Process according to either of the preceding claims, **characterised in that** prior to the local oxidation a part of the boundary surface of the silicide layer located opposite the interface with the silicon-based substrate is covered with a mask.

4. Process according to any one of the preceding claims, **characterised in that** to form the mask an SiO₂ layer is formed on the opposite, in particular, free boundary surface of the silicide layer and an Si₃N₄ layer is formed on said SiO₂ layer, and at least the Si₃N₄ layer is structured in order to form the areas of the silicide layer intended for local oxidation.

5. Process according to any or one of the preceding claims, **characterised in that** the silicide layer has a monocrystalline configuration.

6. Process according to any one of the preceding claims, **characterised in that** the mask is removed after completion of the local oxidation of the silicide layer.

## Revendications

1. Procédé de production d'une structure stratifiée comprenant un couche de siliciure dans lequel on forme celle-ci sur la surface d'un substrat (1) à base de silicium, comprenant les stades qui consistent :
- à mettre une couche de siliciure sur un substrat à base de silicium,
- à oxyder la couche de siliciure localement sur sa surface limite qui est opposée à la surface limite tournée vers le substrat,
une zone locale d'oxyde de silicium étant formée et une zone de silicium diffusant à partir de la surface limite tournée vers le substrat, dans le substrat à base de silicium, **caractérisé en ce que**
- on poursuit l'oxydation jusqu'à ce qu'il se produise par la formation de la zone locale d'oxyde de silicium, une séparation des zones voisines de la couche de siliciure de sorte que la zone superficielle de la couche de siliciure est séparée de la zone profonde.

2. Procédé suivant la revendication précédente, **caractérisé**
**en ce que** l'on forme sur au moins une partie de la surface limite opposée de la couche de silicium, dans la zone prévue pour l'oxydation locale, au moins une autre couche avant l'oxydation locale.

3. Procédé suivant l'une des revendications précédentes, **caractérisé**
**en ce que** l'on revêt avant l'oxydation locale une partie de la surface limite de la couche de silicium qui est opposée à la couche limite tournée vers le substrat à base de silicium, d'un masque.

4. Procédé sur l'une des revendications précédentes, **caractérisé en ce que**, pour la formation du masque sur la surface limite opposée, notamment dégagée, de la couche de siliciure, on forme une couche de SiO₂ et sur celle-ci une couche de Si₃N₄ et pour la formation des zones, prévues pour l'oxydation locale, de la couche de silicium, on structure au moins la couche de Si₃N₄.

5. Procédé suivant l'une des revendications précédentes, **caractérisé en ce que** l'on constitue la couche de siliciure de manière monocristalline.

6. Procédé suivant l'une des revendications précédentes, **caractérisé en ce qu'**après que l'oxydation locale de la couche de siliciure est terminée, on élimine le masque.
